## Europäisches Patentamt
## European Patent Office
## Office européen des brevets

(19)

(11) Veröffentlichungsnummer: **0 078 900**
**B1**

(12) **EUROPÄISCHE PATENTSCHRIFT**

(45) Veröffentlichungstag der Patentschrift:
20.03.85

(51) Int. Cl.⁴: **B 23 K 1/08**

(21) Anmeldenummer: 82108352.4

(22) Anmeldetag: 10.09.82

(54) Vorrichtung zum Aufbringen einer Lotschicht auf eine Leiterplatte.

(30) Priorität: 22.10.81 CH 6744/81

(43) Veröffentlichungstag der Anmeldung:
18.05.83 Patentblatt 83/20

(45) Bekanntmachung des Hinweises auf die Patenterteilung:
20.03.85 Patentblatt 85/12

(84) Benannte Vertragsstaaten:
AT BE CH DE FR GB IT LI LU NL SE

(56) Entgegenhaltungen:
EP - A - 0 013 359
AT - B - 322 944
US - A - 2 993 272
US - A - 3 119 363
US - A - 3 989 180

(73) Patentinhaber: SIEMENS-ALBIS AKTIENGESELLSCHAFT, EGA1/Verträge und Patente Postfach, CH-8047 Zürich (CH)
(84) Benannte Vertragsstaaten: CH LI

(73) Patentinhaber: Siemens Aktiengesellschaft, Berlin und München Wittelsbacherplatz 2, D-8000 München 2 (DE)
(84) Benannte Vertragsstaaten: BE DE FR GB IT LU NL SE AT

(72) Erfinder: Imre, Bajka, Bachenbülacher 8, CH-8172 Niederglatt (CH)
Erfinder: Robert, Furrer, Büttenring 8, CH-6006 Luzern (CH)

EP 0 078 900 B1

## Beschreibung

Die vorliegende Erfindung betrifft eine Vorrichtung gemäss dem Oberbegriff des Patentanspruches 1.

Eine solche Vorrichtung ist aus der US-A Nr. 2993272 zum Verlöten von Bauelementen auf Leiterplatten bekannt. Dabei wird die mit Bauelementen bestückte Leiterplatte horizontal kontinuierlich über den Lotschwall geführt und deren Unterseite und die Anschlüsse der Bauelemente mit Lot beaufschlagt. Bei der Herstellung von Leiterplatten für gedruckte Schaltungen ist es vorteilhaft, schon vor dem Bestückungsvorgang die metallischen Flächen sowohl auf der Ober- als auch auf der Unterseite der Leiterplatte und die Bohrlöcher mit einer schützenden, lötbaren Beschichtung zu versehen, um damit die Lagerhaltungseigenschaften und vorbereitend auch die Löteigenschaften der Platten zu verbessern.

Aus der EP-A Nr. 1-0013359 ist eine Vorrichtung bekannt, die das Aufbringen einer Lötmittelschicht in den Bohrlöchern und auf beide Seiten einer unbestückten Leiterplatte — im Gegensatz zum bisher bekannten vertikalen Eintauchen in eine Lotschmelze — im horizontalen Durchlauf ermöglicht. Diese Vorrichtung besteht aus einem ersten Behälter, aus dem flüssiges Lot in solcher Menge in einen zweiten Behälter gepumpt wird, dass sich darin ein Lötmittelniveau ergibt, welches ständig oberhalb horizontal verlaufender, schlitzförmiger Öffnungen liegt, die an gegenüberliegenden Wänden des zweiten Behälters vorgesehen sind und in der Vorschubebene der Leiterplatten liegen. Die zu beschichtende Leiterplatte wird via die schlitzförmigen Öffnungen durch eine statische Säule flüssigen Lotes hindurchgeschoben und dabei mit Lot beaufschlagt.

Aus der US-A Nr. 3724418 ist eine Vorrichtung zur Beschichtung der Kuperflächen von Leiterplatten bekannt. Diese Vorrichtung weist einen flüssiges Lot enthaltenden Behälter mit einem Kamin auf, der aber keine Leitbleche hat. US-A Nr. 3710759 zeigt eine Vorrichtung zum Aufbringen von Flussmittel auf Leiterplatten, wobei bürstenartige Elemente als Abstreifer für überschüssiges Flussmittel auf der Plattenunterseite dienen.

Ausgehend von der eingangs erwähnten bekannten Vorrichtung (US-A Nr. 2993272) liegt der vorliegenden Erfindung die Aufgabe zugrunde, diese Vorrichtung so auszubilden, dass sie in einer automatisierten Fertigungsstrasse mit horizontalem Durchlauf sowohl ein beidseitiges Aufbringen einer einwandfreien, den heutigen Qualitätsanforderungen entsprechenden Lotschicht auf unbestückte Leiterplatten als auch eine möglichst gleichmässige Beschichtung der durchmetallisierten Bohrlöcher der Leiterplatten gewährleistet. Dies wird erfindungsgemäss mit einer Vorrichtung erreicht, wie sie im Anspruch 1 angegeben ist. Vorteilhafte Weiterbildungen der Erfindung sind in weiteren Ansprüchen umschrieben.

Ein wesentlicher Vorteil der Erfindung liegt darin, dass sie mit relativ einfachen Mitteln und mit dementsprechend geringem Aufwand das an sich bekannte Prinzip des Schwallötens für die heutigen Bedürfnisse der beidseitigen Beschichtung von Leiterplatten sowie der metallisierten Innenwände der Bohrlöcher mit Lot nutzbar macht. Durch die während des ganzen Durchlaufs ständig erzwungene intensive Durchspülung der Bohrlöcher mit Lot in beiden Richtungen wird eine vorzügliche Beschichtung der Bohrlöcher im Innern sowie an deren Randzonen auf beiden Seiten der Platte erreicht. Der durch den voll wirksamen Schwall ständig erzeugte Reibungseffekt zwischen dem flüssigen Lot und den metallischen Flächen ergibt zudem eine optimale Benetzung der Flächen. Eine spezielle Ausbildung der die durchlaufende Leiterplatte berührenden und sowohl als Abstreifer als auch als Begrenzer wirkenden Elemente verhindert weitgehend ein Zurückbleiben von Flussmittelresten auf der Plattenoberfläche.

Nachfolgend wird die Erfindung anhand von Zeichnungen beispielsweise näher erläutert. Es zeigt:

Fig. 1 die wesentlichen Teile der Vorrichtung in einem Schnittbild,

Fig. 2 ein in der Vorrichtung eingesetztes Element zum Begrenzen und Abstreifen des Lotes auf der Leiterplatte, und

Fig. 3 eine Darstellung zur Funktionsweise der Vorrichtung in einem Längs-und in einem Querschnitt.

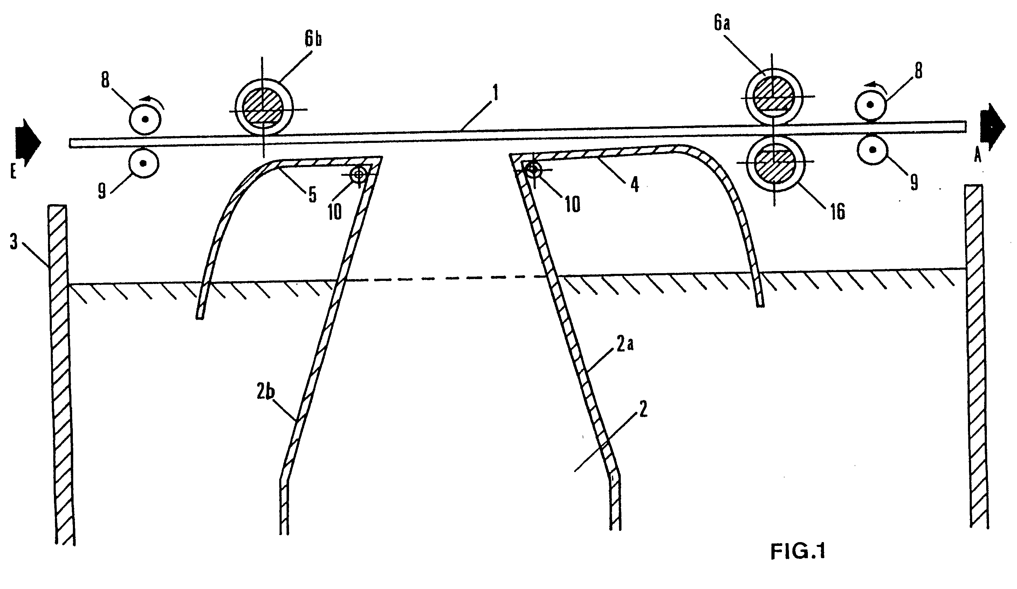

Gemäss Fig. 1 weist die Vorrichtung einen Vorratsbehälter 3 auf, der geschmolzenes Lot enthält, das mittels einer Heizung auf der notwendigen Temperatur gehalten wird. Darin befindet sich ein aus dem Lotbad herausragender, nach oben kaminförmig ausgebildeter Aufbau 2. Sowohl der Aufbau 2 als auch der Vorratsbehälter 3 sind nur teilweise dargestellt. Die Vorschub- bzw. Fortbewegungsebene der beidseitig mit einer Lotschicht zu beaufschlagenden Leiterplatte 1 befindet sich in einem bestimmten Abstand über der Öffnung des Aufbaus 2. Die zuvor beidseiitg mit einem Flussmittel benetzte und vorgewärmte Leiterplatte 1 wird von der Eintrittsseite E her mit einer bestimmten Geschwindigkeit in Richtung Austrittsseite A transportiert. Die Fortbewegung der Leiterplatte 1 kann mit an sich in diesem Zusammenhang bekannten Fördermitteln, beispielsweise mit Walzenpaaren 8, 9, erfolgen, wobei vorzugsweise je eine Walze eines Paares gleichförmig angetrieben ist. Dabei können sich die Walzen über die gesamte Breite der Leiterplatte 1 erstrekken oder aber die Leiterplatte 1 nur teilweise, z. B. im Randbereich, erfassen. Die Anzahl der Walzenpaare auf der Eintritts- bzw. auf der Austrittsseite richtet sich nach der maximalen Länge der zu bearbeitenden Leiterplatte 1 und ist so zu wählen, dass die Leiterplatte 1 während des ganzen Durchlaufes in der Vorschubebene verbleibt. Zwecks Anpassung an unterschiedliche Leiterplattendicken ist wenigstens eine der beiden Walzen eines Paares senkrecht zur Vorschubebene verschiebbar angeordnet.

Am oberen Rand derjenigen Seitenwände 2a, 2b des Aufbaus 2, die quer zur Vorschubrichtung der Leiterplatte 1 verlaufen, ist je ein Leitblech 4 bzw. 5 drehbar angebracht. Dessen Breite entspricht in etwa der Breite der zugehörigen Seitenwand. Die Öffnung des kaminartigen Aufbaus 2 ist in Querrichtung mindestens so lang, vorzugsweise, wie im voliegenden Beispiel, jedoch länger wie die grösste Breite der zu bearbeitenden Leiterplatte 1. Die Leitblechebene verläuft annähernd parallel zur Vorschubebene der Leiterplatte 1. Die Enden der Leitbleche 4, 5 sind vorzugsweise nach unten, d. h. gegen das Innere des Vorratsbehälters 3 hin abgebogen, um ein sauberes Zurückfliessen des Lotes in den Vorratsbehälter 3 zu gewährleisten. Der annähernd parallel zur Vorschubebene der Leiterplatte 1 verlaufende Abschnitt des der Eintrittsseite E zugewandten Leitbleches 5 ist im vorliegenden Ausführungsbeispiel kürzer als derjenige des der Austrittsseite A zugewandten Leitbleches 4, was jedoch nicht zwingend ist. Ebenso ist die aus Fig. 1 ersichtliche unterschiedliche Höhe der Seitenwände 2a, 2b keine Bedingung für die einwandfreie Funktion der Vorrichtung. Der Neigungswinkel der Leitbleche 4, 5 bezüglich der Vorschubebene der Leiterplatte 1 ist mittels entlang der Seitenwände 2a, 2b nach oben und nach unten verschiebbarer Arretierungen 10 wahlweise einstellbar. Dadurch lässt sich die Grösse des Zwischenraumes zwichen den Leitblechen 4, 5 und der Leiterplatte 1 wahlweise verändern.

Zudem ist der Vorratsbehälter 3 gemeinsam mit dem Aufbau 2 in vertikaler Richtung relativ zur Vorschubebene verschiebbar. Die aus Fig. 1 ersichtliche Anordnung mit den in Richtung von der Eintrittsseite E zur Austrittsseite A bezüglich der Vorschubebene leicht ansteigenden Leitblechen 4, 5 unterschiedlicher Länge hat sich in der Praxis als besonders vorteilhaft erwiesen.

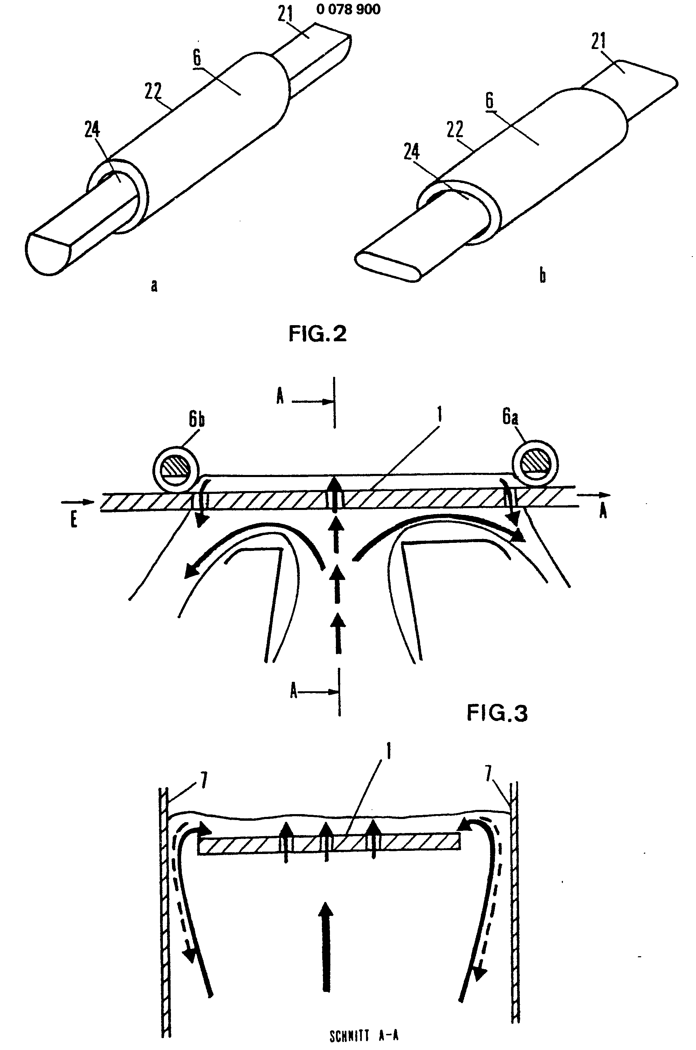

Unmittelbar über der Vorschubebene der Leiterplatte 1 sind über oder zumindest in der Nähe der Biegestelle der Leitbleche 4, 5 quer, beispielsweise senkrecht zur Vorschubrichtung verlaufende, zylinderförmige Elemente 6a, 6b angeordnet. Das im Bereich der Eintrittsseite E der Leiterplatte 1 über dem Lotschwall angeordnete Element 6b dient der Begrenzung des sich beim Durchschieben einer Leiterplatte auf der Leiterplattenoberseite bildenden Lotteppichs, während das andere Element 6a neben der Begrenzung des Lotteppichs auf der Ausgangsseite A zusätzlich die Abstreifung des Lotes und eines Teils der Flussmittelreste auf der die Vorrichtung verlassenden Leiterplatte 1 übernimmt. Einzelheiten der Elemente 6a, 6b sind aus Fig. 2 ersichtlich. Ein Element 6 besteht aus einem Kern 21 und einem Mantel 22. Der Querschnitt des Kerns 21 hat gemäss Fig. 2a z. B. die Form eines Kreissegmentes, während der Mantel 22 z. B. einen kreisringförmigen Querschnitt aufweist. Der Mantel 22 ist so auf dem Kern 21 aufgebracht, dass er sich auf diesem frei drehen kann. Der Kern 21 besteht vorzugsweise aus Metall, z. B. aus Stahl; der Mantel 22 besteht aus einem dauerelastischen, hitzebeständigen Material, vorzugsweise aus einem entsprechenden Kunststoff. Durch die unterschiedlichen Querschnittsformen des Mantels 22 und des Kerns 21 ergibt sich dazwischen ein als Luftpolster wirkender Hohlraum 24. Der Kern 21 der Elemente 6 ist starr in der Vorrichtung befestigt, und zwar so, dass der Hohlraum 24 der Vorschubebene der Leiterplatte 1 zurgewandt ist, d. h. die ebene Fläche des Kerns 21 parallel zur Vorschubebene der Leiterplatte 1 liegt und sich der Kern 21 bei Wärmeeinwikung wenigstens in einer Richtung längs seiner Achse ausdehnen kann. Der Mantel 22 seinerseits kann sich in allen Richtungen frei ausdehnen. Der Hohlraum 24 lässt sich selbstverständlich durch eine Vielzahl anderer Querschnittsformen des Kerns 21 und des Mantels 22 erzeugen. Eine weitere mögliche Ausbildung zeigt Fig. 2b, bei der der Kern 21 einen ellipsenähnlichen Querschnitt aufweist und der Mantel 22 so ausgestaltet ist, dass sich zwischen ihm und dem Kern 21 der Hohlraum 24 ergibt.

Beim Betrieb der Vorrichtung gemäss Fig. 1 wird selbsttätig eine Pumpe eingeschaltet, sobald eine Leiterplatte 1 in den Bereich der Eintrittsstelle E gelangt. Dadurch wird flüssiges Lot innerhalb des Aufbaus 2 nach oben befördert. Die Pumpe wird jeweils wieder selbsttätig ausgeschaltet, wenn die Leiterplatte 1 den Bereich der Austrittsstelle A verlassen hat. Das oben austretende Lot bildet über der Öffnung des Aufbaus 2 einen die Vorschubebene übersteigenden Schwall, dessen Ausbreitung in Richtung Eintritts- und Austrittsseite oberhalb der Vorschubebene durch die Elemente 6b bzw. 6a begrenzt wird und der über die Leitbleche 4, 5 abfliesst. Sobald nun die Leiterplatte 1 von der Eintrittsstelle E her den Bereich des Elementes 6b und des Leitbleches 5 erreicht, gelangt sie zunächst an ihrer Unterseite in Kontakt mit dem heissen Lotschwall, dringt dann in den durch das Element 6b gestauten Lotschwall ein und wird bei fortschreitendem Vorschub kontinuierlich erwärmt. Mit einer optimalen geometrischen Anordnung der Leitbleche 4, 5 in bezug auf die Vorschubebene der Leiterplatte 1 wird erreicht, dass die eingeschobene Leiterplatte 1 einem unsymmetrischen Lotschwall ausgesetzt wird. Die Anordnung lässt sich mit drei Massnahmen optimieren, nämlich:

1. durch Verstellung des Neigungswinkels der Leitbleche 4, 5 zur Vorschubebene,

2. durch Wahl der entsprechenden Höhe der Seitenwände 2a, 2b und damit des Abstandes der Drehachse der Leitbleche 4, 5 von der Vorschubebene, und

3. durch eine vertikale Verschiebung des Vorratsbehälters 3 mit dem Aufbau 2 relativ zur Vorschubebene.

Mit der Pumpenleistung einerseits und dem Abstand des oberen Endes der Seitenwände 2a, 2b zur Vorschubebene andererseits lässt sich die auf die Unterseite der Leiterplatte 1 gelangende Lotmenge festlegen und optimieren. Zusätzlich lässt sich die Strömungsgeschwindigkeit des Lotes insbesondere an der Leiterplattenunterseite durch Veränderung des Neigungswinkels der Leitbleche 4, 5 beeinflussen. Damit kann auch die Abfliessgeschwindigkeit des sich auf der Leiterplattenoberseite bildenden Lotteppichs beeinflusst werden. Durch Optimierung dieser Einflussgrössen wird der erwähnte unsymmetrische Lotschwall erzeugt, bei dem die Menge des gegen die Eintrittsstelle E strömenden Lotes grösser als die gegen die Austrittsstelle A strömende Menge ist. Damit wird die eingeschobene Leiterplatte 1 bereits zu Beginn des Durchlaufs einerseits einer grösstmöglichen Reibung mit dem fliessenden Lot ausgesetzt und ihr andererseits eine genügend grosse Wärmemenge zugeführt, um eine bestmögliche Benet-.zung der metallisierten Flächen mit dem Lot zu gewährleisten. Das flüssige Lot gelangt beim Weiterschieben der Leiterplatte 1 zusätzlich sowohl seitlich als auch durch die Bohrungen der Leiterplatte 1 hindurch in solcher Menge auf die Leiterplattenoberseite, dass sich dort ein zusammenhängender Lotteppich bildet, dessen Ausdehnung durch die beiden Elemente 6a, 6b begrenzt ist. Die Strömungsverhältnisse des Lotes sind in Fig. 3 dargestellt. Aus dem Schnittbild A-A wird insbesondere die auch seitlich stattfindende Strömung des Lotes deutlich. Die seitliche Begrenzung des Lotschwalles erfolgt beidseitig durch Seitenwände 7. Die Durchspülung der Bohrlöcher in vertikaler Richtung sowohl von oben wie von unten gewährleistet deren einwandfreie Beschichtung mit Lot im Falle von durchmetallisierten Löchern. Das über die Leitbleche 4, 5 abfliessende Lot erzeugt eine Sogwirkung, welche die Durchspüung der Bohrlöcher noch begünstigt. Die ständige Durchspülung gewährleistet ein vollständiges Austreiben der Luft aus den Bohrlöchern, was sich vorteilhaft auf die Beschichtung der Innenwände der Löcher auswirkt. Auf diese Weise entsteht ein dynamischer Lotteppich, wodurch alle freien metallisierten Flächen beidseitig ständig einer Reibung mit dem flüssigen Lot ausgesetzt sind, was eine optimale Beschichtung der Leiterplatte 1 mit Lot begünstigt. Das Leitblech 4 auf der Austrittsseite A gewährleistet die Erhaltung der der Leiterplatte 1 zugeführten Wärme durch das über das Leitblech 4 hinwegfliessende Lot, was eine gute Benetzung der metallisierten Flächen mit Lot unterstützt.

Die Länge des in etwa parallel zur Vorschubebene verlaufenden Abschnittes richtet sich daher im wesentlichen nach der durch die Anordnung des Elementes 6a gegebenen Ausdehnung des Lotteppichs in Richtung Austrittsseite A. An sich können die beiden Leitbleche 4, 5 eine beliebige, den jeweiligen Verhältnissen angepasste Länge aufweisen.

Wie erwähnt, übernimmt das Element 6a neben der Begrenzung des Lotteppichs zusätzlich die Funktion der Lotabstreifung auf der Leiterplatte 1. Dank des Luftpolsters 24 passen sich die Elemente 6a, 6b über ihre ganze Länge optimal der Leiterplattenoberfläche an und verhindern das Abfliessen des Lotteppichs über die vorgegebenen Grenzen auf der Leiterplatte 1. Um ein Abstreifen des Lotes auch auf der Leiterplattenunterseite herbeizuführen, kann ein weiteres zylinderförmiges Element 16 unterhalb der Vorschubebene der Leiterplatte 1 vorgesehen werden. Dessen Anordnung erfolgt zweckmässigerweise direkt unter dem Element 6a, wobei die beiden Elemente 6a und 16 die durchlaufende Leiterplatte 1 berühren. Für den Fall unterschiedlicher Leiterplattendicken ist es zweckmässig, wenigstens eines der beiden Elemente 6a und 16 in zur Vorschubebene vertikaler Richtung selbsttätig verschiebbar oder fest einstellbar anzuordnen. Beim Vorschieben der Leiterplatte 1 werden dann die Elemente 6a, 16 je nach Dicke der Leiterplatte 1 mehr oder weniger voneinander getrennt und streifen auf der Unter- und Oberseite der Leiterplatte 1 ab, ohne jedoch ihre Begrenzerwirkung für den Lotteppich zu verlieren. Die Vorschubkraft zum Transport der Leiterplatte 1 lässt sich reduzieren, wenn die Elemente 6a, 6b, 16 nicht genau in senkrechter Richtung zur Vorschubrichtung, sondern in einem kleinen Winkel zur senkrechten Richtung angeordnet werden.

## Patentansprüche

1. Vorrichtung zum Aufbringen einer Lotschicht auf die metallisierten Flächen einer horizontal vorgeschobenen Leiterplatte (1), unter Verwendung eines geschmolzenes Lot enthaltenden Vorratsbehälters (3) und eines aus diesem Vorratsbehälter ragenden kaminartigen Aufbaus, in welchem Lot aus dem Vorratsbehälter derart hochgepumpt wird, dass sich über seiner Austrittsöffnung ein Schwall flüssigen Lotes bildet, und an dessen oberem Rand der beiden quer zur Vorschubrichtung der Leiterplatte stehenden Seitenwände (2a, 2b) Leitbleche (4, 5) mit bezüglich der in einem bestimmten Abstand über der Öffnung verlaufenden Vorschubebene einstellbarem Neigungswinkel angebracht sind, über die der Lotschwall in den Vorratsbehälter zurückfliesst, dadurch gekennzeichnet, dass der Lotschwall eine die Vorschubebene der Leiterplatte (1) übersteigende Höhe aufweist, dass die beiden Leitbleche (4, 5) zumindest teilweise annähernd parallel zur Vorschubebene verlaufen, und dass auf der Eintritts- (E) und auf der Austrittsseite (A) im Bereich der Enden der Leitbleche (4, 5) unmittelbar über der Vorschubebene Elemente (6b, 6a) quer zur Vorschubrichtung angeordnet sind, welche beim Durchlauf der Leiterplatte (1) auf dieser aufliegen und einerseits eine Begrenzung für den sich beim Durchlauf auf der Oberseite der Leiterplatte (1) ausbreitenden Lotteppich auf der Eintrittsseite (E) bzw. auf der Austrittsseite (A) bilden sowie andererseits als Abstreifer auf der Leiterplattenoberfläche wirken.

2. Vorrichtung nach Anspruch 1, dadurch gekennzeichnet, dass auf der Austrittsseite (A) im Bereich des Endes des Leitbleches (4) auch unmittelbar unter der Vorschubebene ein weiteres Element (16) angeordnet ist, welches beim Durchlauf einer Leiterplatte (1) an dieser anliegt.

3. Vorrichtung nach Anspruch 2, dadurch gekennzeichnet, dass wenigstens eines der Elemente (6a, 16) senkrecht zur Vorschubebene der Leiterplatte (1) verschiebbar angeordnet ist.

4. Vorrichtung nach Anspruch 3, dadurch gekennzeichnet, dass die Elemente (6a, 6b, 16) aus einem mit einem Mantel (22) überzogenen Kern (21) bestehen, wobei der Kern (21) starr befestigt und der Mantel (22) fest oder drehbar auf dem Kern (21) aufgebracht ist, und dass zwischen dem Kern (21) und dem Mantel (22) ein als Luftpolster wirkender Hohlraum (24) vorhanden ist, der der Vorschubebene zugewandt ist.

5. Vorrichtung nach Anspruch 4, dadurch gekennzeichnet, dass der Kern (21) einen kreissegmentförmigen und der Mantel (22) einen kreisringförmigen Querschnitt aufweist, dass der Kern (21) aus Metall besteht und sich axial wenigstens in einer Richtung ausdehnen kann, und dass der Mantel (22) aus einem dauerelastischen, hitzebeständigen Kunststoff besteht, der in allen Richtungen frei ausdehnbar ist.

6. Vorrichtung nach einem der vorangehenden Ansprüche, dadurch gekennzeichnet, dass die Leitbleche (4, 5) in Richtung von der Eintrittsseite (E) zur Austrittsseite (A) leicht ansteigend, d. h. mit bezüglich der Vorschubebene sich verringerndem Abstand angeordnet sind.

7. Vorrichtung nach Anspruch 6, dadurch gekennzeichnet, dass das der Eintrittsseite (E) zugewandte Leitblech (5) kürzer ist als das der Autrittsseite (A) zugewandte Leitblech (4).

8. Vorrichtung nach einem der vorangehenden Ansprüche, dadurch gekennzeichnet, dass der Vorratsbehälter (3) gemeinsam mit dem Aufbau (2) in vertikaler Richtung relativ zur Vorschubebene verschiebbar ist.

## Claims

1. A device for the dispersion of a solder layer on the metallized surfaces of a horizontally fed printed-circuit board, using a storage container containing molten solder and a chimney-shaped superstructure which protrudes from the storage container and into which is pumped up from the storage container in such a way that a surge of liquid solder is formed above its outlet opening, and, at the upper edges of the two lateral walls of the container, which are transversely arranged to the feed direction of the printed-circuit board, baffle plates are arranged which have an angle of inclination which is adjustable in respect of the feed plane extending at a predetermined distance above the opening, by means of which baffle plates the solder surge flows back into the storage container, characterised in that the solder surge has a level which exceeds the feed plane of the printed-circuit board (1), that the two baffle plates (4, 5) at least partially extend approximately parallel to the feed plane, and that on the inlet side (E) and the outlet side (A), in the region of the ends of the baffle plates (4, 5) directly above the feed plane, elements (6b, 6a) are arranged tranversely to the feed direction, which elements, during the passage of the printed-circuit board (1), rest upon the latter and, on the one hand, delimit the solder covering, which during the passage spreads out on the upper side of the printed-circuit board (1), at the inlet side (E) and the outlet side (A), and, on the other hand, operate as skimmers at the surface of the printed-circuit board.

2. A device as claimed in Claim 1, characterised in that a further element (16), which during the passage of a printed-circuit board (1) rests on the latter, is arranged at the outlet side (A), in the region of the end of the baffle plate (4) immediately below the feed plane.

3. A device as claimed in Claim 2, characterised in that at least one of the two elements (6a, 16) is arranged so as to be displaceable at right angles to the feed plane of the printed-circuit board (1).

4. A device as claimed in Claim 3, characterised in that the elements (6a, 6b, 16) consist of a core (21) which is covered with a casing (22), the core (21) being rigidly fastened and the casing (22) being fixedly or rotatably fitted on the core (21), and that a space (24), which faces towards the feed plane and acts as an air-cushion, is arranged between the core (21) and the casing (22).

5. A device as claimed in Claim 4, characterised in that the core (21) has a cross-section shaped like a segment of a circle and the casing (22) has a cross-section shaped like a circular ring, that the core (21) is made of metal and can extend axially in at least one direction, and that the casing (22) consists of a permanently elastic, heat-resistant synthetic resin which can expand freely in all directions.

6. A device as claimed in one oí the preceding claims, characterised in that the baffle plates (4, 5) rise slightly in the direction from the inlet side (E) to the outlet side (A), i.e. they are arranged at a distance which decreases with respect to the feed plane.

7. A device as claimed in Claim 6, characterised in that the baffle plate (5) facing the inlet side (E) is shorter than the baffle plate (4) facing the outlet side (A).

8. A device as claimed in one of the preceding claims, characterised in that the storage container (3), together with the superstructure (2), is displaceable in the vertical direction relative to the feed plane.

## Revendications

1. Dispositif pour déposer une couche de matériau de soudure sur les surfaces métallisées d'une plaque à circuits imprimés déplacée horizontalement, avec mise en œuvre d'un réservoir de réserve contenant le matériau de soudure fondu et d'une structure en forme de cheminée débordant du réservoir de mesure et dans laquelle le matériau est refoulé vers le haut, hors du réservoir de réserve, de telle manière qu'il se forme au-dessus de son ouverture de sortie une vague de matériau de soudure liquide et, sur le bord supérieur de ses deux parois latérales qui sont disposées tranversalement à la direction d'avancement des plaques à circuits imprimés, des tôles de guidage sont agencées avec un angle d'inclinaison réglable par rapport au plan d'avancement qui se situe à une certaine distance au-dessus de l'ouverture, tôles par-dessus lesquelles la vague de soudure revient dans le réservoir de réserve, caractérisé par le fait que la vague de matériau de soudure possède une hauteur qui dépasse le plan d'avancement de la plaque à circuits imprimés (1), que les deux tôles de guidage (4, 5) s'étendent au moins en partie à peu près parallèlement au plan d'avancement et que, sur le côté entrée (E) et sur le côté sortie (A), dans la zone des extrémités des tôles de guidage (4, 5), immédiatement au-dessus du plan d'avancement, sont disposés, transversalement à la direction d'avancement, des éléments (6b, 6a) qui, au passage de la plaque à circuits imprimés (1), portent sur ceux-ci et, d'une part, forment une limitation pour le tapis de matériau de soudure qui s'étale au passage sur le côté supérieur de la plaque de circuits imprimés, du côté entrée (E) ou du côté sortie (A) et, d'autre part, agissent comme raclettes sur la surface de la plaque à circuits imprimés.

2. Dispositif selon la revendication 1, caractérisé par le fait que, du côté sortie (A) et dans la zone de l'extrémité de la tôle de guidage (4), se trouve disposé, également immédiatement en dessous du plan d'avancement, un élément supplémentaire (16) qui, au passage d'une plaque à circuits imprimés (1), porte sur celle-ci.

3. Dispositif selon la revendication 2, caractérisé par le fait qu'au moins l'un des deux éléments (6a, 16) est disposé perpendiculairement au plan d'avancement de la plaque à circuits imprimés (1), de façon à pouvoir être déplacé.

4. Dispositif selon la revendication 3, caractérisé par le fait que les éléments (6a, 6b, 16) sont constitués par un noyau (21) revêtu d'une enveloppe (22), étant noté que le noyau (21) est fixé rigidement et que l'enveloppe (22) est disposée de façon fixe ou de façon à pouvoir tourner sur le noyau (21), et qu'entre le noyau (21) et l'enveloppe (22) est ménagé un espace vide (24) agissant comme un coussin d'air, lequel espace vide est situé du côté du plan d'avancement.

5. Dispositif selon la revendication 4, caractérisé par le fait que le noyau (21) présente la forme d'un segment de cercle et l'enveloppe (22) présente une section transversale en forme d'anneau, que le noyau (21) est fait avec un métal et peut s'étendre axialement au moins dans une direction, et que l'enveloppe (22) est constituée par une matière plastique résistant à la chaleur et présentant une élasticité durable, en pouvant s'étendre dans toutes les directions.

6. Dispositif selon l'une des revendications précédentes, caractérisé par le fait que les tôles de guidage (4, 5) grimpent légèrement en direction du côté entrée (E) au côté sortie (A), ce qui signifie qu'elles sont disposées à une distance qui diminue par rapport au plan d'avancement.

7. Dispositif selon la revendication 6, caractérisé par le fait que la tôle de guidage (5) qui est située du côté entrée (E) est plus courte que la tôle de guidage (4) qui est située du côté sortie (A).

8. Dispositif selon l'une des revendications précédentes, caractérisé par le fait que le réservoir de réserve (3) est, avec la structure (2), déplaçable en direction verticale par rapport au plan d'avancement.

FIG.1

0 078 900

FIG.2

FIG.3

SCHNITT A-A